# EUROPEAN PATENT SPECIFICATION

(11) **EP 0 532 133 B1**
(45) Date of publication and mention of the grant of the patent: **03.04.1996**
(21) Application number: 92203738.7
(22) Date of filing: 10.12.1986
(51) Int. Cl.: H01S 3/23, G06K 15/12

(54) **Laser array**
Vielfachanordnung von Lasern
Réseau à laser

(30) Priority: 12.12.1985 US 808197
(43) Date of publication of application: 17.03.1993
(62) Divisional of application: 86309597.2
(73) Proprietor: XEROX CORPORATION, Rochester New York 14644 (US)
(72) Inventor: Thornton, Robert L., East Palo Alto, California 94303 (US); Sang, Henry W., Jr., Santa Clara, California 95051 (US); Paoli, Thomas L., Los Altos, California 94022 (US); Burnham, Robert D., Palo Alto, California 94306 (US)
(74) Representative: Reynolds, Julian David

(56) References cited:
- EP-A- 0 112 076
- EP-A- 0 115 390
- JP-A-60 186 082
- US-A- 4 445 125
- APPLIED PHYSICS LETTERS. vol. 47, no. 5, 1 September 1985, NEW YORK US pages 450-452 Thomas L.PAOLI et al.: "High-power multiple-emitter AlGaAs superluminescent diodes"
- APPLIED PHYSICS LETTERS. vol. 46, no. 9, 1 May 1985, NEW YORK US pages 857 - 859 P. GAVRILOVIC ET AL. 'Impurity-disordered, coupled-stripe AlxGa1-xAs-GaAs quantum well laser'

## Description

This invention relates to incoherent non-phase-locked laser arrays and in particular non-phase-locked or optically-uncoupled laser arrays having a broad uniform far field with high intensity which are highly adaptable for use as illuminating sources with electro-optic line modulators and electro-optic line printers.

In the prior art, semiconductor lasers and light-emitting diodes (LEDs) have been employed as a light source to produce an image on a photosensitive medium such as a xerographic photoreceptor used in a xerographic printer. In this kind of application, there is a need for uniformity of the intensity of light in the image as well as sufficient intensity of the light emitted. Further, if LEDs have to be utilized, it is necessary to provide a full width array of LEDs, one per picture element or pixel so that a line of light can be formed for discharge of the photoreceptor in an imagewise manner. Usually a plurality of light-emitting device arrays are arranged in one or more rows, and optical means is positioned between the photosensitive medium and the light source array to focus the light from the array sources to a single line on the surface of the photosensitive medium. The light sources are selectively turned on and off to effect line-by-line exposure of the moving photosensitive medium.

Semiconductor lasers have also been used in the past as such light sources for rotary prism scanned printers because of their high intensity in a focussed spot. They have not, however, been totally best suited for application in electro-optic line printers because of inadequate power and inadequate uniformity of light intensity. In particular, high-power coherent laser sources possess a far field pattern containing regions of high intensity and of low intensity in the single beam far field, i. e., the far field pattern is not uniform. Such a variation in intensity across the beam output is not desired because the line exposure on the photosensitive medium will not be uniform. For this and other reasons, LEDs have been more favored as a light source for electro-optic line printers because they may be designed to provide a light output of monotonically varying intensity with very short coherence length.

In some cases, LEDs in the past have not provided sufficient output power and intensity to accomplish in an efficient manner the task of exposing a charged and moving photosensitive medium. In addition, an LED is much less efficient than a laser. For this reason, LEDs as light sources for xerographic photoreceptor applications have lacked the output intensity level for good photoreceptor discharge and as a result, semiconductor lasers have been still favored in many cases as the light source for printer applications.

Beside the problem of sufficiency of LED intensity, the maintenance of light output uniformity among a plurality of LEDs, as well as a multiple laser source, as alluded to above, is a recognized problem in the art. To ensure that the intensity of the broad light emission from the array is uniform across an LED array, elaborate control systems have been designed to provide for light intensity uniformity, as exemplified, for example, in US-A-4,455,562. This patent utilizes a binary-weighted duty cycle control to obtain substantial uniformity in the light emitted from each LED in the array of LEDs.

The highest power LEDs have been top emitter types, but they lack the power density necessary for most printer applications, i.e., they lack sufficient light density per aperture size.

A most recent advancement in the printer art has been the concept of a total internal reflection (TIR) line modulator, which is a solid state multigate light valve which may be used to address a photosensitive medium. The line TIR modulator comprises a crystal bar of electro-optic material with an array of interdigital electrodes deposited on one of its major surfaces, which electrodes, when electrically addressed, introduce or induce a periodic electric field into the bulk crystal. Each of the electrodes may be individually addressed by an electronic signal to form a signal pattern across the array. A broad or wide sheet-like beam of high intensity light is required for the line modulator. The beam is introduced into the crystal at an angle incident to the plane of the major surface incorporating the electrodes. An example of the line TIR modulator is disclosed in US-A-4,281,904.

To carry out the exposure process of the photosensitive medium, a sheet-like beam of light is transmitted through the electro-optic element of the TIR line modulation at a slight angle relative to the optical axis of the light, to cause total internal reflection at the internal surface incorporating the electrode array. Successive sets of digital bits or analog samples, representing respective collections of picture elements or pixels for successive lines of an image, are sequentially applied to the electrode array. Localized electric bulk or fringe fields developed in the crystal in proximity to the TIR incidence of light modulate the light and change the phase front of the sheet-like light beam in imagewise configuration on to the charged photosensitive medium. Examples and teachings relative to electro-optic line printer applications may be found in US-A-4,367,925; 4,369,457; 4,370,029; 4,437,106; 4,450,459; 4,480,899 and 4,483,596.

More recently, a super-luminescent LED side-facet source has been developed for electro-optic line modulation and line printers which is characterized by having high output intensity and a uniform far field emission and optical means to collimate the far field emission in the tangential direction and focus the near field in the sagittal direction onto the modulator. The optical means comprises a first lens system to collect the light emitted from the LED source in both the tangential and sagittal directions and a second toric lens to collimate the light into a sheetlike beam in the tangential direction and to focus the light in the sagittal direction to a line image at the modulator. Imaging means is optically aligned between the modulator and the record medium for imaging the modulator on to the record medium of a line printer.

Such an LED has nearly ideal characteristics as an optical source in printing applications utilizing multigate or electro-optic modulators because its radiation pattern is broad and varies monotonically in a predictable way without the sharp or irregular structure encountered with a diode laser array. In addition, the optical spectrum of the LED is sufficiently broad that optical interference effects are negligible. However, an LED inherently has a lower overall efficiency, e.g. conversion efficiency, than a diode laser since LED light is emitted in many different directions and also this requires that the LED of comparable output power operates at higher temperatures and higher input power than the diode laser source.

JP-A-60 186 082 discloses a semiconductor laser array comprising a non-planar active layer sandwiched between two cladding layers and having embodied in it several spatially-separated laser emitters such that each emitter is diagonally displaced from the or each adjacent emitter.

Thus, an optical source with the incoherence of an LED but the efficiency of a diode laser is desirable for line modulator and printer applications.

Accordingly this invention provides an incoherent diode laser array as claimed in the appended claim 1.

In order to produce an array of closely-spaced lasers on a single chip which operate in an optically uncoupled manner, it is necessary to reduce the strength of the evanescent field extending from each laser cavity to adjacent laser cavities below a level required for accomplishing stable phase-locking. This decoupling may be accomplished in several ways, First, for example, in a laser array of conventional gain-guided lasers, the individual laser elements must be separated by a relatively large distance, e. g., on the order of 50 µm or more, in order to achieve uncoupled operation. However, separation of the laser elements in the array by such a large distance leads to reduced efficiency because of the substantial amount of wasted current spread away from the active regions of the individual laser elements and the inability to collect the light in the far field efficiently for particular applications, such as electro-optic modulators and line printers. In addition, for large separations, the far field of the total array becomes nonuniform because of the decreased overlap of the far field patterns of the individual laser emitters, which would render this type of structure unsuitable for electro-optic line printers. In the case of an array of index-guided lasers, the matter of far field separation would be better satisfied, since the individual laser emitters need not be separated as far because of the tighter optical field confinement provided by the individual lasers of such an array. For both index-guided and gain-guided laser arrays, optical absorption can be introduced between the lasers in order to eliminate the leakage of light from one laser into an adjacent laser waveguide or cavity at the cost of increased threshold and decreased efficiency. A closely-spaced uncoupled array without optical absorption is the most desirable situation.

The present invention provides the necessary close spacing of the laser emitters of the array while sustaining uncoupled lasing operation by either diagonal displacement of the individual laser emitters or by forming regions of isolation between the laser cavities of the array using impurity-induced disordering (IID). The desired end is to isolate the optical cavities of the individual cavities of the lasers so that there will be no optical coupling between them.

The present invention will now be described by way of example, with reference to the accompanying drawings, in which:
Figure 1 is a schematic side view of an electro-optic line printer to carry out the present invention;
Figure 2 is a plan view of the line printer shown in Figure 1;
Figure 3 is an enlarged side view of a TIR multigate line modulator;
Figure 4 is an enlarged bottom view of the modulator shown in Figure 3 to illustrate the individually addressable electrodes of the modulator, and
Figure 5 is a schematic illustration of an incoherent laser array for use with the printer shown in Figure 1.

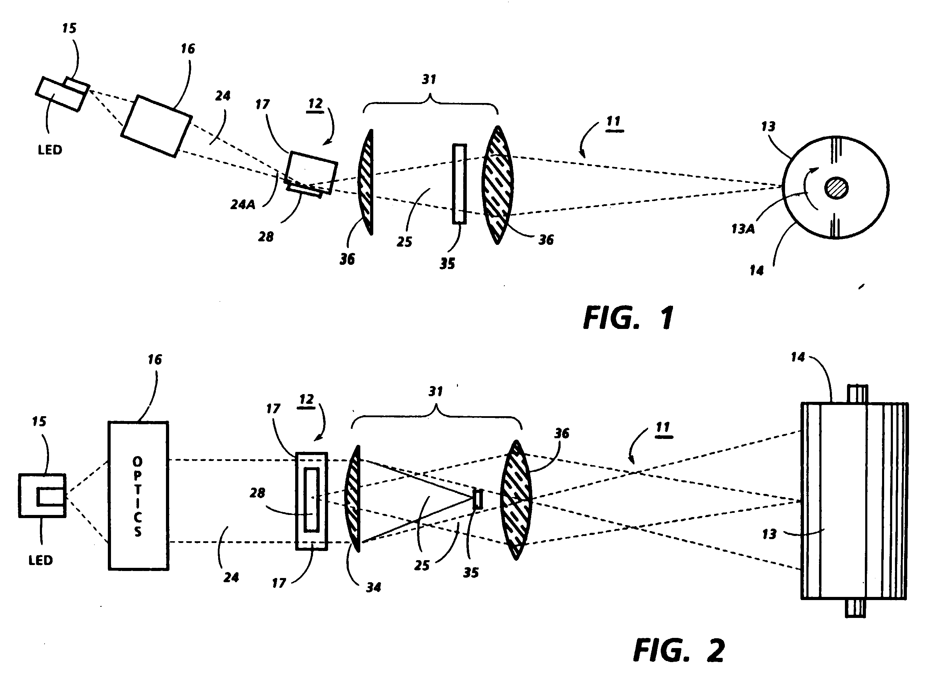

In Figures 1 and 2, there is shown an electro-optic line printer 11 having a fringe field responsive multigate light valve or TIR line modulator 12 for printing an image on a photosensitive record medium 13. As shown, the record medium 13 is a photoconductively coated drum 14 which is rotated (by means not shown) in the direction indicated by arrow 13A. Other xerographic and non-xerographic record media could be used, including photoconductively coated belts and plates, as well as photosensitive films and coated papers. Thus, in the generalized case, the record medium 13 should be visualized as being a photosensitive medium which is exposed while advancing in a cross-line or line-pitch direction relative to modulator 12.

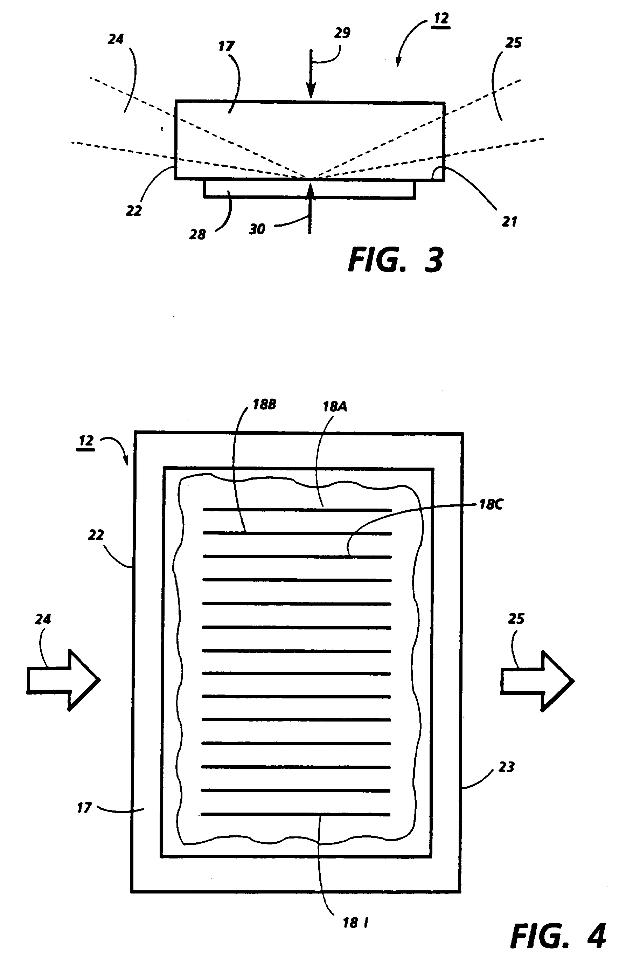

As best illustrated in Figures 3 and 4, modulator 12 comprises an optically transparent electro-optic element 17 and a plurality of individually addressable electrodes 18A-18I. The most promising electro-optic materials for such a device presently appear to be LiNbO₃ and LiTaO₃, but there are others which warrant consideration, including DSN, KDP, Kd^{x}P, Ba₂NaNb₅O₁₅ and PLZT. In this particular embodiment, modulator 12 is operated in a TIR mode. Thus electro-optic element 17 is suitably a y-cut crystal of, say LiNbO₃ having an optically polished reflecting surface 21 extending between opposed, optically-polished, input and output faces 22 and 23, respectively. Typically, each of the electrodes 18A-18I is 1 to 30 µm wide, and the interelectrode gap spacing is 1 to 30 µm.

Referring to Figures 1 through 4 for a brief review of the operation of modulator 12, it will be seen that a sheetlike collimated light beam 24 from an incoherent laser array light source 15 is transmitted, via front end optics 16, through input face 22 of electro-optic element 17 at a grazing angle of incidence relative to reflecting surface 21, i.e., at an angle no greater than the critical angle of incidence for total internal reflectance from that surface.

The input beam 24 is laterally expanded by optics so that it more or less uniformly illuminates substantially the full width of the electro-optic element 17 and is brought to a wedge shaped focus 24A by optics 16 on the reflecting surface 21 approximately midway through electro-optic element 17. Accordingly, input beam 24 is totally internally reflected from reflecting surface 21 to provide an output beam 25 which exits from the electro-optic element 17 through its output face 23.

The phase front or the polarization of output beam 25 is spatially modulated in accordance with the data applied to electrodes 18A-18I. More particularly, if the data create a voltage drop between any adjacent pair of electrodes, such as electrodes 18B and 18C, a corresponding fringe field is coupled into electro-optic element 17, thereby producing a localized variation in its refractive index. To couple such fringe fields efficiently into electro-optic element 17, electrodes 18A-18I are supported on or very near reflecting surface 21 thereof. Electrodes 18A-18I preferably are deposited on a suitable substrate, such as a VLSI silicon circuit 28, which is pressed or otherwise firmly held against electro-optic element 17, as indicated by the arrows 29 and 30, to maintain electrodes 18A-18I in contact with, or at least closely adjacent, reflecting surface 21. The advantage of this construction is that VLSI circuit 28 may be used to make the necessary electrical connections to electrodes 18A-18I. Alternatively, electrodes 18A-18I could be deposited on reflecting surface 21 of electro-optic element 17.

For illustrative purposes, it has been assumed that the phase front of the output beam 25 is spatially modulated in accordance with the data applied to electrodes 18A-18I. Accordingly, Schlieren central dark field or bright field imaging optics are used to convert the phase front modulation of the output beam 25 into a correspondingly modulated intensity profile and to supply any magnification that may be needed to obtain an image of the desired size at the surface of record medium 13. More particularly, as shown, there is a central dark field imaging optics 31 comprising a field lens 34, a central stop 35, and an imaging lens 36. The field lens 34 is optically aligned between output face 23 of electro-optic element 17 and stop 35 to focus substantially all of the zero-order diffraction components of the output beam 25 onto stop 35. However, the higher-order diffraction components of output beam 25 scatter around stop 35 and are collected by imaging lens 36 which, in turn, focuses these components onto record medium 13 to provide an intensity-modulated image of modulator 12.

Referring again to Figure 4, it will be noted that each of the electrodes 18A-18I is individually addressable. Therefore, to print an image, differentially encoded data samples for successive lines of the image are sequentially applied to electrodes 18A-18I. As a matter of definition, each differentially encoded data sample, other than the first sample for each line of the image, has a magnitude which differs from the magnitude of the previous differentially encoded sample by an amount corresponding to the magnitude of a particular input data sample. The first differentially encoded sample for each line is referenced to a predetermined potential, such as ground. Thus, when the differentially encoded data samples for any given line of the image are applied to electrodes 18A-18I, the picture elements for that line are faithfully represented by the electrode-to-electrode voltage drops at modulator 12.

To supply the differentially encoded data samples, serial input data samples representing adjacent picture elements or pixels for successive lines of an image are applied to a differential encoder at a predetermined data rate. The encoder differentially encodes these input samples on a line-by-line basis, and a multiplexor ripples the encoded data samples onto electrodes 18A-18I at a ripple rate which is matched to the data rate. The input data may be buffered to match the input data rate to any desired ripple rate.

Alternatively, a set of ground plane electrodes (i.e., not shown, but being electrodes referenced to the same voltage level as the raw input data samples) may be interleaved with the individually addressable electrodes, thereby avoiding the need for differential encoding. As a general rule, however, the advantages of reducing the number of electrodes required to achieve a given resolution justify the additional circuitry needed for differential encoding.

For printer 11 in the sagittal direction, optics 16 images the near field light from laser array source, which may, for example, be one quarter to one µm wide spot, onto modulator 12. This spot image is imaged down to be one diffraction-limited spot wide in modulator 12. The output 25 from modulator 12 is then broadened out, for example, to a 10 µm spot for a one µm source spot. In the tangential direction, the light is collimated by the optics 16 at modulator 12 so that it is illuminated with the far field of laser array source 15.

Thus, each adjacent pair of electrodes, such as the electrodes 18B and 18C shown in Figure 4, cooperate with electro-optic element 17 and readout optics 31 to define effectively a local modulator for creating a picture element or pixel at a unique, spatially-predetermined, position along each line of an image to be replicated at medium 13.

Reference is now made to the type of laser array desirable for utilization with line printer 11. In general, the emitters of the laser array must not be phase-locked but have to be sufficiently closely spaced for the far field pattern to be a uniform emission pattern of Gaussian form, which emitter composite pattern corresponds to the far field emission pattern of the individual laser emitters or laser elements of the array. In other words, the spatial criteria for the emitters are that they must be spatially close enough to form a uniform far field pattern but at the same time not provide phase locking between adjacent emitters. This is a difficult situation because, as the prior art shows, phase-locking occurs when the spacing of emitters is close, but if the emitter separation is increased to an extent to eliminate stable phase-locking, the far field emission pattern will not be uniform because of the large distance between emitters, and there will remain far field lobes and irregularities preventing uniformity across the far field pattern.

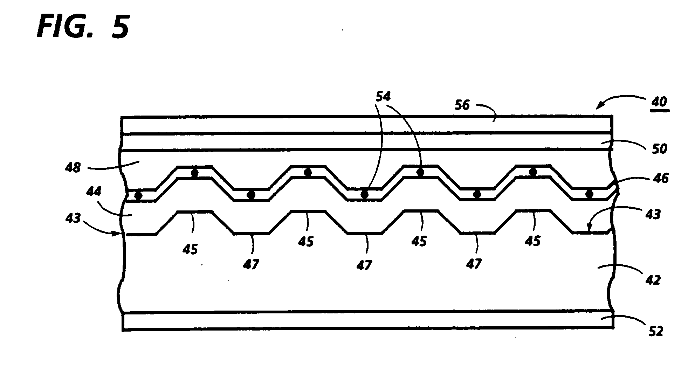

Thus, it is necessary to introduce some mechanism or means by which the emitters may be sufficiently closely spaced but not phase-locked, i.e., remain incoherent relative to one another and the net optical intensity in the far field is the added effect of the optical intensities of the individual emitters. The mechanism or means may be in the form of either lateral displacement of the emitters in their geometry, or isolation imposed between the individual emitters for an index-guided laser array structure. An example of lateral emitter displacement is illustrated in Figure 5.

Figure 5 illustrates incoherent laser array 40 having a plurality of closely-spaced laser elements which are formed by incorporating offset laser element geometry. In Figure 5, the individual emitters are optically uncoupled in the array, therefore not phase-locked, by displacing each laser element in the vertical and lateral directions. The structure for laser array 40 may comprise, for example, a substrate 42 of n-GaAs which is selectively etched by conventional techniques to provide the periodic structure 43 of alternating mesas 45 and channels 47. Then, metal-organic chemical vapor depositions (MO-CVD) growth techniques are utilized to grow semiconductor layers 44-48 epitaxially. The layers relevant to the laser structure are: cladding layer 44, of n-Ga₁₋ₓALₓAs, where x may be 0.4; active region 46, which may be comprised of a single active layer or a single quantum well structure or a multiple quantum well structure; a cladding layer 48, of n-Ga₁₋ₓAlₓAs, where x may be 0.4; and a cap layer of p + -GaAs. Laser array 40 may be provided with appropriate proton or ion implant to provide for enhanced current confinement to the regions of the individual emitters 54, and further provided with a Cr-Au or Ti-Pt-Au metalization 56 on cap layer 70, and an alloyed Au-Ge layer, followed by a Cr-Au or Ti-Pt-Au metalization 52 on the bottom surface of substrate 42.

The lateral separation of individual laser emitters 54 in this nonplanar array can be made dimensionally less thin compared with a planar array of emitters, because the optical field of each emitter in the vertical direction is very tightly confined by the strong optical waveguide formed by the periodic structure 43 and propagated through layers 44-48. For example, a vertical lateral displacement of 2 to 3 µm between the laser cavities represented by emitters 54 is adequate to eliminate optical coupling between adjacent laser elements and yet permit closer lateral or horizontal spacing than would be possible in a planar array. Also, the closer spacing using the displacement geometry of laser array 40 utilizes more efficiently the applied pumping current to the array. The minimum lateral separation of the laser emitters will depend upon the vertical plane separation but can be made less than 10 µm.

Other alloy systems may be used to fabricate the laser arrays utilized herein with visible emission wavelengths, e.g., InGaP/InGaAsP/InGaP or AlGaInP/InGaP/AlGaInP.

## Claims

1. An incoherent, optically-uncoupled, semiconductor laser array (40) comprising a layer (46) of active material sandwiched between two layers (44, 48) of cladding material of which one replicates the alternating channel and mesa cross-sectional shape of the surface of a substrate (42), the active layer having embodied in it a plurality of laser emitters (54) of which each is substantially at the centre of a longitudinal strip of the active layer, the strips being spaced apart both laterally and vertically by such distances that the optical field of each emitter in the vertical direction is confined very tightly by the optical waveguide formed by the substrate surface (43) and propagated through the active and cladding layers, so that each incremental emitter is optically isolated from its adjacent emitters.

2. A laser array as claimed in claim 1, in which the layer (46) of active material is cranked in cross-section, whereby each emitter is displaced diagonally from the or each adjacent emitter.

## Patentansprüche

1. Eine inkohärente, optisch nichtgekoppelte Halbleitermehrfachanordnung (40), die eine Schicht (46) aus einem aktiven Material umfaßt, das zwischen zwei Schichten (44, 48) aus Hüllmaterial zwischengefügt ist, von denen eine die Querschnittsform aus abwechselndem Kanal und Mesa der Oberfläche eines Substrats (42) wiederholt, wobei in der aktiven Schicht eine Vielzahl von Laseremittern (54) verkörpert sind, von denen jeder im wesentlichen in der Mitte eines länglichen Streifens der aktiven Schicht ist, wobei die Streifen seitlich und vertikal mit solchen Abständen beabstandet sind, daß das optische Feld von jedem Emittern in der vertikalen Richtung sehr eng durch den optischen Wellenleiter begrenzt ist, der durch die Substratoberfläche (43) gebildet ist, und sich durch die aktive Schicht und Hüllschichten hindurch fortpflanzt, so daß jeder schrittweise Emitter optisch von seinen benachbarten Emittern isoliert ist.

2. Eine Lasermehrfachanordnung, wie in Anspruch 1 beansprucht, in der die Schicht (46) aus aktivem Material im Querschnitt gekröpft ist, wodurch jeder Emitter diagonal von dem oder jedem benachbarten Emitter verschoben ist.

## Revendications

1. Réseau laser à semi-conducteur incohérent non couplé optiquement (40) comprenant une couche (46) de matériau actif prise en sandwich entre deux couches (44, 48) de matériau de placage dont l'une duplique la forme à section en coupe de canal et de table en alternance de la surface d'un substrat (42), la couche active comportant incorporée dans celle-ci une multitude d'émetteurs laser (54) dont chacun est pratiquement au centre d'une bande longitudinale de la couche active, les bandes étant espacées à la fois latéralement et verticalement sur des distances telles que le champ optique de chaque émetteur dans la direction verticale soit confiné très étroitement par le guide d'onde optique formé par la surface du substrat (43) et se propage au travers des couches active et de placage, de façon à ce que chaque émetteur incrémental soit isolé optiquement de ses émetteurs contigus.

2. Réseau laser selon la revendication 1, dans lequel la couche (46) de matériau actif présente une section en coupe crénelée, d'où il résulte que chaque émetteur est décalé en diagonale de l'émetteur contigu ou de chaque émetteur contigu.
